# FASCICULE DE BREVET EUROPEEN

(11) **EP 2 761 055 B1**
(45) Date de publication et mention de la délivrance du brevet: **05.10.2016**
(21) Numéro de dépôt: 12761635.7
(22) Date de dépôt: 24.09.2012
(51) Int. Cl.: C23C 18/14, C23C 18/12, H01L 31/0392, H01L 31/048, H01L 51/52, H01L 51/10

(54) **STRUCTURE MULTICOUCHE OFFRANT UNE ETANCHEITE AUX GAZ AMELIOREE**
MEHRSCHICHTIGE STRUKTUR MIT VERBESSERTER GASDICHTHEIT
MULTILAYER STRUCTURE OFFERING IMPROVED IMPERMEABILITY TO GASES

(30) Priorité: 26.09.2011 FR 1158570
(43) Date de publication de la demande: 06.08.2014
(73) Titulaire: Commissariat à l'Énergie Atomique et aux Énergies Alternatives, 75015 Paris (FR)
(72) Inventeur: CROS, Stéphane, F-73000 Chambery (FR); ALBEROLA, Nicole, F-73100 Aix Les Bains (FR); GARANDET, Jean-Paul, F-73370 Le Bourget Du Lac (FR); MORLIER, Arnaud, F-74130 Faucigny (FR)
(74) Mandataire: Ahner, Philippe
(86) Numéro de dépôt international: PCT/EP2012/068766
(87) Numéro de publication internationale: WO 2013/045393

(56) Documents cités:
- JP-A- 2003 211 579
- US-A1- 2007 026 243
- US-A1- 2010 166 977
- LUTZ PRAGER ET AL: "Conversion of Perhydropolysilazane into a SiOx Network Triggered by Vacuum Ultraviolet Irradiation: Access to Flexible, Transparent Barrier Coatings", CHEMISTRY - A EUROPEAN JOURNAL, vol. 13, no. 30, 15 octobre 2007 (2007-10-15), pages 8522-8529, XP055026020, ISSN: 0947-6539, DOI: 10.1002/chem.200700351

## Description

### DOMAINE TECHNIQUE ET ART ANTÉRIEUR

La présente invention se rapporte à une structure multicouche offrant une étanchéité aux gaz améliorée.

Il est connu de réaliser un dépôt d'une couche mince, typiquement entre 100 nm et plusieurs centaines de nm, en matériau inorganique dense sur substrat polymère épais, typiquement de 10 µm à quelques centaines de µm, par exemple un substrat en PET (Polyéthylène téréphtalate) afin d'améliorer son étanchéité aux gaz. Cette technique est largement utilisée dans le domaine de l'emballage alimentaire pour améliorer la conservation des aliments.

Cependant ce dépôt inorganique génère des contraintes mécaniques liées notamment aux différentiels de comportements mécanique et thermique entre la couche inorganique et le polymère, i.e. la différence de modules élastiques, de capacités de déformation, la différence d'expansion thermique... Ces contraintes occasionnent un endommagement de la couche inorganique déposée, ce qui a pour effet de limiter ses propriétés fonctionnelles. Des fissures peuvent alors apparaître, qui réduisent les propriétés barrière aux gaz de l'ensemble formé par le substrat polymère et le dépôt inorganique.

Le document US 2003/0203210 décrit un procédé consistant à réaliser des empilements alternés de couches inorganiques et de couches de polymère, ayant une épaisseur de 1 µm à quelques µm sur le substrat polymère épais. L'alternance de couches inorganiques et organiques permet alors de décorréler les défauts de chaque couche inorganique et ainsi d'améliorer considérablement les propriétés barrière aux gaz. Le substrat polymère ainsi recouvert possède des propriétés barrière aux gaz suffisantes pour protéger des dispositifs fortement sensibles à l'atmosphère tels que les dispositifs d'optoélectronique organique ou OLED (Organic Light Emitting Diodes). Cependant de telles structures alternées ont un coût de réalisation relativement élevé, ce qui les rend peu adaptées à des applications bas coût, comme par exemple des applications photovoltaïques. Le document US 2007/0026243 décrit une structure multicouche barrière aux gaz comportant une couche d'oxyde de silicium entre deux couches d'oxynitrure de silicium.

### EXPOSÉ DE L'INVENTION

C'est par conséquent un but de la présente invention d'offrir un dispositif présentant une structure offrant des propriétés barrière aux gaz augmentées par rapport à celles des structures de l'état de la technique et un procédé de réalisation d'une telle structure et présentant un coût de réalisation réduit par rapport aux procédés existants.

Le but précédemment énoncé est atteint par une structure multicouche formée d'un substrat, d'au moins une couche en matériau de type SiOₓN_{y}H_{z} et au moins une couche de SiO₂, la couche en matériau de type SiOₓN_{y}H_{z} étant destinée à être interposée entre le substrat et la couche de SiO₂. La couche de type SiOₓN_{y}H_{z} forme une couche d'accommodation mécanique entre le substrat et la couche de SiO₂ et permet d'adapter les contraintes entre le substrat et la couche de SiO₂ ce qui évite ou limite la détérioration de la couche de SiO₂, améliorant donc l'étanchéité aux gaz de la couche de SiO₂.

En d'autres termes, on réalise une couche formant une interface mécanique entre le substrat et la couche de SiO₂ plus épaisse et moins rigide que la couche de SiO₂, qui permet d'éviter la rupture de la couche de SiO₂.

Le substrat est par exemple un substrat polymère, de préférence transparent.

Cet empilement bicouche peut être répété, un tel empilement offre des propriétés de propriétés barrière aux gaz remarquables, bien supérieures à celles attendues par la somme des propriétés barrière aux gaz de deux empilements bicouches.

Dans un autre exemple de réalisation, une couche d'un autre matériau peut être déposée sur la structure bicouche, par exemple en polymère.

La structure selon l'invention est obtenue par exemple par la conversion par irradiation VUV et UV d'un précurseur de type perhydropolysilazane liquide (PHPS).

De manière très avantageuse, la formation de la couche de SiO₂ et la formation de la couche en matériau de type SiOₓN_{y}H_{z} sont simultanées et se font dans des conditions spécifiques appauvries en oxygène et en eau.

La présente invention a alors pour objet une structure multicouche comportant un substrat, et un premier empilement d'une couche de SiO₂ et une couche en matériau de type SiOₓN_{y}H_{z} disposée entre le substrat et la couche de SiO₂, dans laquelle la couche de SiO₂ et la couche en matériau de type SiOₓN_{y}H_{z} présentent des épaisseurs telles que l'épaisseur de la couche de SiO₂ est inférieure ou égale 60 nm, l'épaisseur de la couche en matériau de type SiOₓN_{y}H_{z} est supérieure à deux fois l'épaisseur de la couche de SiO₂ et la somme des épaisseurs de la couche de SiO₂ et de la couche en matériau de type SiOxNyHz est comprise entre 100 nm et 500 nm et dans laquelle z est strictement positif et est strictement inférieure au rapport (x+y)/5, avantageusement z est strictement inférieur au rapport (x+y)/10.

De manière très avantageuse, la valeur de x décroît de l'interface entre le couche en matériau de type SiOₓN_{y}H_{z} et la couche de SiO₂ vers le substrat, et la valeur de y croît de l'interface entre le couche en matériau de type SiOxNyHz et la couche de SiO₂ vers le substrat. De préférence, x varie de 2 à 0 et/ou y varie de 0 à 1.

Selon une autre caractéristique avantageuse, le matériau de la couche de SiO₂ présente un module d'Young supérieur ou égal à 30 GPa et la couche en matériau de type SiOxNyHz a un module d'Young inférieur ou égal à 20 GPa.

L'empilement peut présenter un indice de réfraction supérieur à 1,5.

Selon une autre caractéristique avantageuse, le ou les empilements est ou sont obtenu(s) par conversion d'un précurseur inorganique de type perhydropolysilazane, l'empilement présentant une transmittance correspondant à la liaison Si-H supérieure à 80%, avantageusement supérieure à 90%, de la transmittance de la liaison Si-H du précurseur inorganique de type perhydropolysilazane avant conversion, mesurée par spectrométrie infrarouge en réflexion dans le cas d'un substrat en matériau polymère. Ou , le ou les empilements est ou sont obtenu(s) par conversion d'un précurseur inorganique de type perhydropolysilazane, l'empilement présentant une absorbance correspondant à la liaison Si-H inférieure à 20%, avantageusement inférieure à 10%, de l'absorbance de la liaison Si-H du précurseur inorganique de type perhydropolysilazane avant conversion, mesurée par spectrométrie infrarouge en transmission dans le cas d'un substrat en silicium.

La couche de SiO₂ et la couche en matériau de type SiOₓN_{y}H_{z} sont par exemple en matériaux amorphes.

Par exemple, le substrat est en matériau polymère.

La structure multicouche peut comporter une couche en matériau polymère sur la couche de SiO₂ du premier empilement sur la face opposée à celle en contact avec la couche en matériau de type SiOₓN_{y}H_{z}.

Selon un autre exemple de réalisation, la structure multicouche peut comporter n empilements, n étant un entier positif supérieur ou égal à 1, chaque empilement comportant chacun une couche de (SiO₂)ᵢ et une couche en matériau de type SiOₓᵢN_{yi}H_{zi}, i étant un entier positif compris entre 1 et n, les couches de (SiO2)ᵢ et en matériau de type SiOₓᵢN_{yi}H_{zi} de chaque empilement ayant des épaisseurs telles que l'épaisseur des couches de (SiO₂)ᵢ est inférieure ou égale 60 nm, l'épaisseur des couches en matériau de type SiOₓᵢN_{yi}H_{zi} est supérieure à deux fois l'épaisseur de la couche de (SiO₂)ᵢ et la somme des épaisseurs de la couche de (SiO₂)ᵢ et de la couche en matériau de type SiOₓᵢN_{yi}H_{zi} est comprise entre 100 nm et 500 nm et dans laquelle zᵢ est strictement inférieur au rapport (xᵢ+yᵢ)/5, avantageusement zᵢ est strictement inférieur au rapport (xᵢ+yᵢ)/10, xᵢ, yᵢ, zᵢ étant identiques ou non pour les différents valeurs de i. La structure multicouche peut également comporter au moins une couche en matériau polymère disposée entre la couche de (SiO₂)ᵢ d'un empilement et la couche en matériau de type SiOₓᵢN_{yi}H_{zi} de l'empilement suivant directement. Par exemple, la structure multicouche comporte n-1 couches en matériau polymère, chacune des couches en matériau polymère étant disposée entre deux empilements.

La présente invention a également pour objet un procédé de réalisation d'une structure multicouche selon l'invention, comportant :
a) le dépôt sur un substrat d'un précurseur inorganique liquide de type perhydropolysilazane,
b) la conversion par irradiation par des rayonnements VUV à une longueur d'onde inférieure ou égale à 220 nm et un rayonnement ultraviolet à une longueur d'onde supérieure ou égale à 220 nm sous une atmosphère présentant un taux d'oxygène supérieur à 10 ppm et inférieur à 500 ppm et un taux d'eau inférieur ou égal à 1000 ppm, de sorte à former un empilement d'une couche de SiO₂ et une couche en matériau de type SiOₓN_{y}H_{z}.

Le procédé de réalisation peut comporter l'étape c) de dépôt d'une couche de matériau polymère après l'étape b).

Selon un autre exemple de réalisation, le procédé de réalisation comporte la répétition des étapes a) et b) ou a), b) et c).

La présente invention a également pour objet un procédé de réalisation d'une structure multicouche, comportant :
a') le dépôt sur un substrat d'un précurseur inorganique liquide de type perhydropolysilazane sur le substrat,
b') la conversion par irradiation par des rayonnements ultraviolet à une longueur d'onde supérieure à 220 nm sous une atmosphère présentant un taux d'oxygène et un taux d'eau inférieurs à 10 ppm,
c') le dépôt sur la couche formé à l'étape b', d'un précurseur inorganique liquide de type perhydropolysilazane sur le substrat,
d') la conversion par irradiation par des rayonnements VUV à une longueur d'onde inférieure ou égale à 220 nm sous une atmosphère présentant un taux d'oxygène supérieur à 10 ppm et inférieur à 500 ppm.

### BRÈVE DESCRIPTION DES DESSINS

La présente invention sera mieux comprise à l'aide de la description qui va suivre et des dessins en annexe sur lesquels :
- la figure 1 est une représentation schématique vue de côté d'un exemple d'une structure selon l'invention,
- la figure 2 est une représentation schématique vue de côté d'un autre exemple de structure,
- la figure 3 est une représentation graphique de la mesure du flux d'eau de la structure de la figure 2 en fonction du temps en jour,
- la figure 4 est une représentation schématique vue de côté d'un autre exemple de structure selon l'invention,
- la figure 5 est une représentation schématique vue de côté d'une variante de la structure de la figure 4.

### EXPOSÉ DÉTAILLÉ DE MODES DE RÉALISATION PARTICULIERS

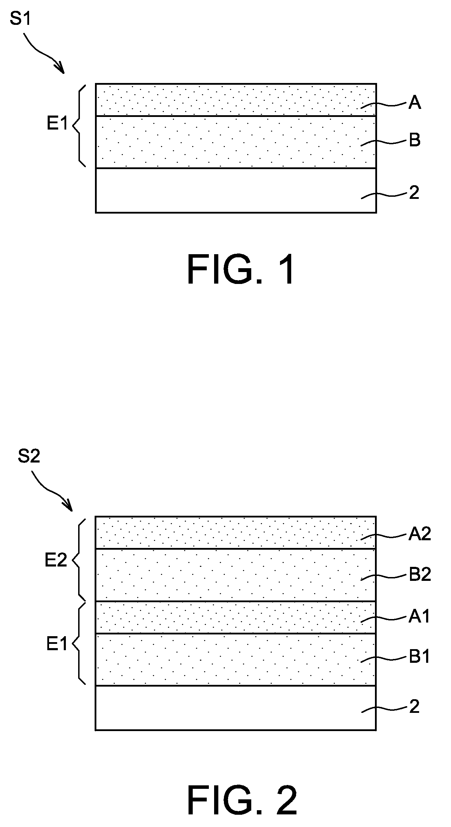

Sur la figure 1, on peut voir une structure S1 selon l'invention comportant un substrat 2 et un empilement E1 d'une première couche A en SiO₂ et une deuxième couche B en matériau de type SiOₓN_{y}H_{z}.

Les couches A et B sont en distinctes l'une de l'autre et sont réalisées en des matériaux différents.

Le substrat 2 est par exemple un matériau polymère, par exemple de type polyester comme le PET (polyéthylène téréphtalate), le PEN (polyéthylène naphtalate), ou de type polyoléfine comme le PE (polyéthylène), le PP (polypropylène), le polyamide.... D'autres matériaux sont envisageables comme substrat, par exemple le silicium monocristallin ou amorphe, ou le verre.

De préférence le substrat est transparent.

La deuxième couche B est déposée directement sur le substrat 2 et s'interpose entre le substrat 2 et la première couche A.

La première couche A a une épaisseur e_{A}, et un module d'Young M_{A}, et la deuxième couche B a une épaisseur e_{B}, et un module d'Young M_{B}.

Les épaisseurs des première A et deuxième B couches B sont telles que :
- e_{A} ≤ 60 nm
- e_{B} ≥ 2e_{A};
- 100 nm < e_{A}+ e_{B}< 500 nm.

En outre, les coefficients x pour l'oxygène, y pour l'azote et z pour l'hydrogène de la formule chimique du matériau de la couche B en SiOₓN_{y}H_{z} sont tels que 0 < z < (x+y)/5, avantageusement 0 < z < (x+y)/10.

De préférence, les coefficients x et y varient depuis l'interface entre la couche A et la couche B en direction de l'interface entre le substrat et la couche B. x décroît depuis l'interface entre la couche A et la couche B en direction de l'interface entre le substrat et la couche B, de préférence de 2 jusqu'à 0; y croît depuis l'interface entre la couche A et la couche B en direction de l'interface entre le substrat et la couche B, de préférence de 0 jusqu'à 1.

De manière avantageuse, les modules d'Young des première A et deuxième B couches sont tels que :
- MA > 30 GPa, et
- M_{B} < 20 GPa.

Ces conditions avantageuses sur les modules d'Young des couches A et B permettent d'améliorer encore les propriétés barrière aux gaz.

La mesure des modules d'Young des couches A et B peuvent être réalisés suivant les techniques décrites dans les documents "A simple guide to détermine elastic properties of films on substrate from naoindentation experiments", S. Bec, A. Tonck and J Loubet, in Philosophical Magazine, Vol.86, Nos. 33-35, 21 NOv.-11 Dec.2006, pp5347-5358 et dans le document *"*In vivo measurements of the elastic mechanical properties of human skin by indentation tests", in Medical Engineering & Physics, 30(2008) pp599-606*.*

L'indice de réfraction de la structure S1 est de préférence supérieur à 1,5.

Les matériaux des couches A et B peuvent être amorphes.

La deuxième couche B étant plus épaisse que la première couche A et étant moins rigide que la couche A, du fait de son module d'Young plus faible, celle-ci permet d'adapter les contraintes entre la première couche A et le substrat 2 et ainsi d'éviter la rupture de la première couche A. En outre, la deuxième couche B permet de limiter la déformation de la structure formée par le substrat 2 et la structure bicouche liée au phénomène de déformation différentielle entre la première couche A et le substrat 2, qui pourrait se traduire par une courbure de l'ensemble.

La première couche A en SiO₂ du fait de sa densité offre naturellement des propriétés d'étanchéité aux gaz. Grâce à la présence de la deuxième couche B qui forme une couche d'adaptation mécanique, les propriétés d'étanchéité aux gaz de la première couche A ne sont pas ou peu dégradées.

La quantité de liaisons Si-H restante après conversion du PHPS dans les couches A et B est très faible. Cette caractéristique peut être mesurée en spectrométrie infrarouge à transmission ; la bande correspondant aux liaisons Si-H est comprise entre 2100 et 2300 cm⁻¹ (nombre d'onde). L'absorbance correspondant à la liaison Si-H de la structure de l'invention est inférieure à 20%, de préférence inférieure à 10%, de l'absorbance de la liaison Si-H du PHPS avant traitement. Cette absorbance en transmission peut être mesurée lorsque le dépôt est effectué sur substrat transparent aux infra rouge, tel qu'un substrat en silicium. Cette faible quantité de Si-H peut également être détectée lorsque la structure est déposée sur un substrat polymère. La mesure est alors effectuée en réflexion et la transmittance dans la gamme de nombre d'onde 2100-2300 cm⁻¹ est supérieure à 80%, de préférence supérieure à 90%.

Nous allons maintenant décrire un exemple de procédé de réalisation en une seule étape de la structure S1.

On recouvre une face du substrat 2 avec un précurseur inorganique liquide, par exemple de type perhydropolysilazane.

On irradie ensuite le précurseur au moyen d'un rayonnement ultraviolet lointain ou ("VUV: Vacuum Ultraviolet" en terminologie anglo-saxonne) de longueur d'onde inférieure ou égale à 220 nm et un rayonnement UV de longueur d'onde supérieure ou égale à 220 nm.

Par exemple, l'irradiation se fait au moyen d'une lampe mercure basse pression qui combine une longueur d'onde VUV de 185 nm et une longueur d'onde UV de 254 nm. Le dépôt et la conversion sont faits, par exemple, à température ambiante. La dose reçue pour le rayonnement à 185 nm est par exemple inférieure à 20 joules/cm².

Avec la manière avantageuse décrite ci-dessus, les couches A et B sont réalisées simultanément dans un procédé en une étape. A cette fin, l'étape de conversion est réalisée dans un milieu appauvri en oxygène et en eau afin de limiter l'épaisseur de la couche A ainsi que la conversion de la couche B, ce qui permet d'obtenir les caractéristiques des couches mentionnées ci-dessus.

Le milieu appauvri présente :
- un taux d'oxygène inférieur à 500 ppm,
- un taux d'eau inférieur ou égal à 1000 ppm.

De manière alternative, le procédé peut se dérouler en deux étapes: lors d'une première étape, une couche d'un précurseur inorganique liquide, par exemple de type perhydropolysilazane, est déposée sur le substrat, cette couche est ensuite soumise à une irradiation UV de longueur d'onde supérieure à 220 nm avec une présence d'oxygène et d'eau négligeables, i.e. inférieure à 10 ppm. Lors d'une deuxième étape, une autre couche du même précurseur inorganique que celui de la première couche est déposée sur la première couche, cette deuxième couche subit une irradiation par VUV à une longueur d'onde supérieure à 220 nm en présence d'oxygène, la concentration d'oxygène est alors comprise entre 10 ppm et 500 ppm.

Sur la figure 2, on peut voir un exemple de structure offrant des propriétés de barrière aux gaz remarquables.

La structure S2 comporte un substrat 2, un premier empilement E1, qui est identique à celui de la structure S1, et un empilement E2 comportant une couche de SiO₂ A2 et une couche B2 en matériau de type SiO_{x'}N_{y'}H_{z'}. La couche B2 est déposée directement sur la première couche A1 de la structure S1 telle que décrite précédemment en relation avec la figure 1. Les épaisseurs des couches A2 et B2 sont telles que :
- e_{A2} ≤ 60 nm
- e_{B2} ≥ e_{A2} ;
- 100 nm < e_{A2}+ e_{B2} < 500 nm.

Les coefficients x' pour l'oxygène, y' pour l'azote et z' pour l'hydrogène de la formule chimique du matériau de la couche B2 sont identiques ou différents des coefficients x, y, z du matériau de la couche B1 en SiOₓN_{y}H_{z} respectivement. Comme pour la couche B1, x', y', z' sont tels que z' < (x'+y')/5, avantageusement z' < (x'+y')/10. De plus, de préférence, x' et y' varient depuis l'interface entre la couche A2 et la couche B2 en direction du substrat. x' décroît depuis l'interface entre la couche A2 et la couche B2 en direction du substrat, de préférence de 2 jusqu'à 0; y' croît depuis l'interface entre la couche A2 et la couche B2 en direction du substrat, de préférence de 0 jusqu'à 1.

Les épaisseurs de couches A2 et B2 ainsi que leurs modules d'Young peuvent être égaux à ceux des couches A1 et B1 respectivement ou différents.

Comme la couche B1, la couche B2 permet de préserver l'intégrité de la couche A2 et donc d'optimiser ses propriétés fonctionnelles. En outre, lors du dépôt des couches A2 et B2, la couche B1 permet de limiter les problèmes mécaniques, en particulier la courbure de la structure formée par le substrat 2 et les deux empilements bicouches.

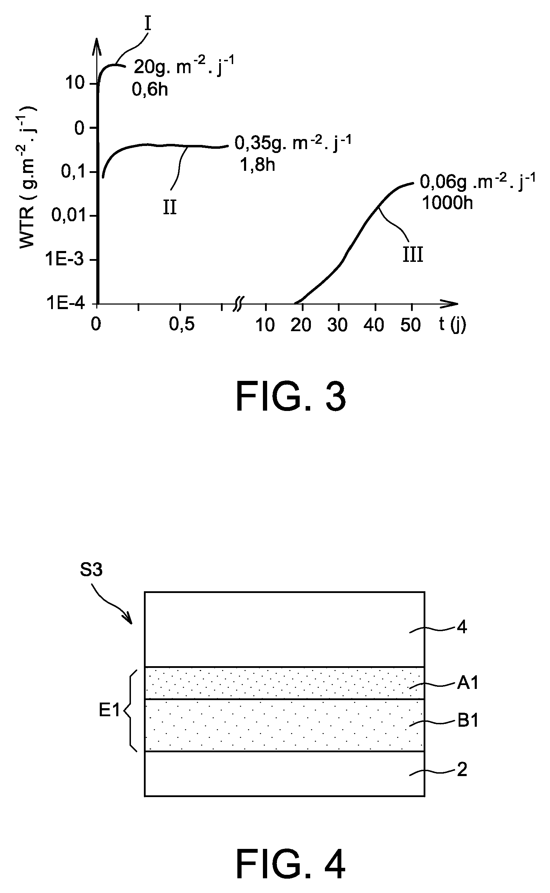

La structure S2 montre des propriétés barrière aux gaz remarquables comme le montre la représentation graphique de la figure 3. Sur celle-ci on peut voir la mesure du flux d'eau en g.m⁻².jour⁻¹, désignée WVTR, en fonction du temps en jour.

Ces mesures sont effectuées pour trois empilements :
I : un substrat en polymère PET seul,
II : la structure S1 selon l'invention, avec e_{A} = 50 nm et e_{B} = 200 nm,
III : la structure S2 selon l'invention, avec e_{A1} = e_{A2} = 50 nm et e_{B1} = e_{B2} = 200 nm.

En complément de la figure 3, le tableau 1 ci-dessous répertorie les propriétés barrière et les indices de réfraction des structures S1 et S2 en comparaison de structure forme d'un substrat PET et d'une couche de silice seule de 250 nm ou de 600 nm d'épaisseur réalisée par hydrolyse en température (80°C) de perhydropolysilazane ou d'une couche de silice de 50 nm obtenues par conversion VUV. Dans ce tableau les propriétés barrière sont exprimées en termes de "Barrier Improvement Factor (BIF qui exprime le facteur d'amélioration par rapport au substrat PET seul. Des mesures de perméation à l'eau et à l'hélium ont été effectuées.

| **Echantillon** | **BIF He** | **BIF eau** | **BIF oxygène** | **Indice de réfraction** |
|---|---|---|---|---|
| **PET** | 1 | 1 | 1 | - |
| **S1** | 3,5+/-0,5 | 60 | 40 | 1,62 |
| **S2** | 7,5+/-0,5 | 333 | N.D. | N.D. |
| **PET + 250 nm SiO₂ (hydrolyse PHPS)** | 1,5+/-0,5 | 2 | 2 | 1,45+/-0,01 |
| **PET + 600 nm SiO₂ (hydrolyse PHPS)** | 1,5+/-0,5 | 3,5+/-0,5 | 6+/-2 | 1,45+/-0,01 |
| **PET + 50 nm SiO₂ VUV** | 1,2+/-0,2 | N.D. | N.D. | 1,46 |

| | | | | |
|---|---|---|---|---|
| N.D .signifie "non déterminée". | | | | |

Dans le tableau 1, on constate que l'amélioration des propriétés barrière du ET par l'ajout d'une couche de SiO₂ de 250 nm ou de 600 nm est beaucoup plus faible que celle conférée par la structures S1 et a fortiori la structure S2. De même la réalisation d'une couche de Si02 de 50 nm par irradiation VUV dans les conditions d'atmosphère décrites précédemment mais hors des gammes d'épaisseurs de l invention ne permet pas d'obtenir des propriétés barrière satisfaisantes du fait de l'absence de la couche B d'accommodation mécanique.

S2 selon la présente invention présente des propriétés barrière aux gaz améliorées de manière importante par rapport à des structures ne comportant qu'un substrat et une couche de silice.

En comparant les courbes I et II, on constate une augmentation des propriétés barrière aux gaz grâce à l'invention.

En comparant les courbes II et III, on remarque une réduction notable du flux d'eau largement supérieure à ce qui peut être attendu dans le cas d'une simple addition des propriétés de deux barrières aux gaz des deux bicouches. En effet la structure S1, le flux d'eau atteint 0,35 g.m⁻².j⁻¹ et dans le cas de la structure S2 le flux d'eau atteint 0,06 g.m⁻².j⁻¹.

La propriété la plus remarquable est l'augmentation considérable du temps de stabilisation de la mesure (ou "time lag" en anglais) de la structure S2 par rapport à la structure S1, puisque pour la structure S1, le temps de stabilisation est de 1,8 heures et pour la structure S2, il est de 1000 heures, celui-ci est donc multiplié par facteur supérieur à 500.

La couche B2 présente une ténacité et une densité importantes, sa densité qui est inférieure à celle de la couche A2 reste cependant largement supérieure à celle du substrat en polymère.

Ainsi, la couche B2 comprise entre la couche Al et la couche A2, ralentit la progression des gaz à travers les couches A1 et A2.

On peut envisager une structure avec plus de deux empilements bicouches, un nombre n quelconque d'empilements bicouches est envisageable, n étant un entier positif. L'effet sur l'augmentation de la barrière aux gaz est encore augmenté. Les couche de chaque empilement présentent des épaisseurs relatives et un module d'Young tels que décrits précédemment.

La structure S2 peut être réalisée en répétant le procédé de réalisation de la structure S1. On recouvre la couche de SiO₂ de la structure S1 d'un précurseur inorganique de type perhydropolysilazane, on le convertit au moyen de rayonnements VUV et UV de longueurs d'onde correspondant à celles décrites précédemment; le dépôt du deuxième empilement bicouche peut s'effectuer également en une étape dans une atmosphère remplissant les conditions précisées ci-dessus.

Sur la figure 4, on peut voir un autre exemple de structure S3 selon l'invention. La structure S3 comporte la structure S1 de la figure 1 et une couche 4 en matériau polymère, ce matériau peut être identique ou différent de celui du substrat 2.

En variante, la couche 4 pourrait être réalisée avec des matériaux hybrides tels que les organosilanes.

La structure S4 peut former, outre une barrière aux gaz, une barrière à d'autres éléments, par exemple aux rayons UV. Elle peut former une barrière thermosoudable ou une barrière présentant une fonction additionnelle, comme par exemple former une zone d'impression.

Grâce à la couche B, les problèmes d'ordre mécanique lors du dépôt de la couche en matériau polymère 4 sont limités, tels que la courbure de l'ensemble de l'empilement.

La couche 4 est déposée par exemple en solution puis par évaporation et/ou polymérisation si cela est requis.

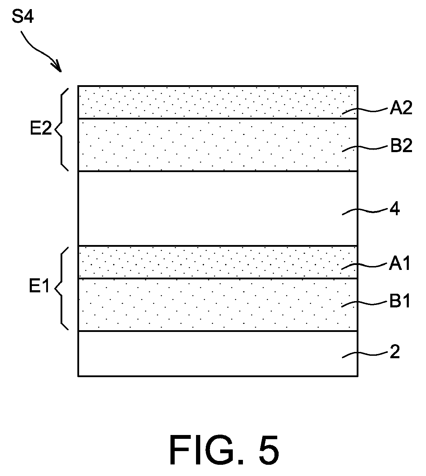

Sur la figure 5, on peut voir une structure S4 qui est une combinaison de la structure S2 et de la structure S3, dans laquelle l'empilement E2 des couches A2 et B2 est réalisé sur la couche en matériau polymère 4, la couche B2 de type SiOₓN_{y}H_{z} étant déposée sur la couche en matériau polymère 4.

Comme pour la structure S2, les épaisseurs des couches A1 et A2, B1 et B2 respectivement peuvent être identiques ou différentes.

La couche en matériau polymère 4 peut renforcer l'effet d'adaptation mécanique apporté par la couche B2 et/ou apporter des propriétés spécifiques autres, par exemple comme la flexibilité de l'ensemble ou des propriétés anti-UV ou absorbeurs d'humidité.

La structure S4 offre des propriétés fonctionnelles, en particulier barrières aux gaz similaires à celles de la structure S2.

Le procédé de réalisation de la structure S4 comporte la réalisation de la structure 3 et le procédé de réalisation de la structure S1 sur la couche 4.

On peut prévoir des structures comportant n empilements bicouches Eᵢ et n-1 couches de polymère 4 pour lesquelles les propriétés fonctionnelles sont démultipliées du fait de la mise en série de n couches denses Aᵢ en SiO₂ et des n-1 couches d'interposition en matériau polymère.

La structure selon l'invention déposée sur un substrat en matériau polymère offre des propriétés barrière aux gaz améliorée et peut être transparente. Un tel niveau d'étanchéité ne peut être obtenu par des technologies classiques de dépôts, telles que le dépôt physique en phase vapeur, le dépôt chimique en phase vapeur ou le sputtering. De plus, le mode de dépôt par voie humide permet de limiter le coût du procédé et de réaliser des membranes formant des barrières aux gaz très efficaces à faible coût contrairement à des technologies utilisant des chambres à vide tel le dépôt de couches atomiques (ALD pour "Atomic layer Deposition" en terminologie anglo-saxonne) ou le procédé Barix® de la société VITEX.

La structure formée par le substrat polymère et l'empilement selon l'invention à faible coût peut être utilisée comme protection de dispositifs sensibles à l'atmosphère, en particulier sensibles à l'eau et à l'oxygène, tels que les dispositifs électronique organique (OLED, OTFT), les dispositifs solaires couches minces (CIGS) ou encore plus généralement pour réaliser des récipients pour des contenus sensibles à l'humidité. Le coût réduit d'une telle structure permet une utilisation dans des domaines très variés.

## Revendications

1. Structure multicouche comportant un substrat (2), et un premier empilement d'une couche (A) de SiO₂ et une couche (B) en matériau de type SiOₓN_{y}H_{z} disposée entre le substrat (2) et la couche (A) de SiO₂, dans laquelle la couche (A) de SiO₂ et la couche (B) en matériau de type SiOₓN_{y}H_{z} présentent des épaisseurs (e_{B}, e_{A}) telles que l'épaisseur de la couche (A) de SiO2 est inférieure ou égale 60 nm, l'épaisseur de la couche (B) en matériau de type SiOₓN_{y}H_{z} (e_{B}) est supérieure à deux fois l'épaisseur (e_{A}) de la couche (A) de SiO₂ et la somme des épaisseurs de la couche (A) de SiO₂ et de la couche (B) en matériau de type SiOₓN_{y}H_{z} est comprise entre 100 nm et 500 nm et dans laquelle z est strictement positif et est strictement inférieur au rapport (x+y)/5, avantageusement z est strictement inférieur au rapport (x+y)/10.

2. Structure multicouche selon la revendication 1, dans laquelle la valeur de x décroît de l'interface entre le couche en matériau de type SiOₓN_{y}H_{z} (B) et la couche de SiO₂ vers le substrat, et la valeur de y croît de l'interface entre le couche en matériau de type SiOₓN_{y}H_{z} (B) et la couche de SiO₂ vers le substrat.

3. Structure multicouche selon la revendication 2, dans laquelle x varie de 2 à 0 et/ou y varie de 0 à 1.

4. Structure multicouche selon l'une des revendications 1 à 3, dans laquelle le matériau de la couche (A) de SiO₂ présente un module d'Young supérieur ou égal à 30 GPa et la couche (B) en matériau de type SiOₓN_{y}H_{z} a un module d'Young (M_{B}) inférieur ou égal à 20 GPa.

5. Structure multicouche selon l'un des revendications 1 à 4, dont l'empilement présente un indice de réfraction supérieur à 1,5.

6. Structure multicouche selon la revendication 4 ou 5, dans laquelle le ou les empilements est ou sont obtenu(s) par conversion d'un précurseur inorganique de type perhydropolysilazane, l'empilement présentant une transmittance correspondant à la liaison Si-H supérieure à 80%, avantageusement supérieure à 90%, de la transmittance de la liaison Si-H du précurseur inorganique de type perhydropolysilazane avant conversion, mesurée par spectrométrie infrarouge en réflexion dans le cas d'un substrat en matériau polymère.

7. Structure multicouche selon la revendication 4 ou 5, dans laquelle le ou les empilements est ou sont obtenu(s) par conversion d'un précurseur inorganique de type perhydropolysilazane, l'empilement présentant une absorbance correspondant à la liaison Si-H inférieure à 20%, avantageusement inférieure à 10%, de l'absorbance de la liaison Si-H du précurseur inorganique de type perhydropolysilazane avant conversion, mesurée par spectrométrie infrarouge en transmission dans le cas d'un substrat en silicium.

8. Structure multicouche selon l'une des revendications 1 à 7, dans laquelle la couche (A) de SiO₂ et la couche (B) en matériau de type SiOₓN_{y}H_{z} sont en matériaux amorphes.

9. Structure multicouche selon l'une des revendications 1 à 8, dans laquelle le substrat (2) est en matériau polymère.

10. Structure multicouche selon la revendication 9, dans laquelle le substrat (2) est un matériau polymère de type polyester comme le polyéthylène téréphtalate (PET), le polyéthylène naphtalate (PEN) ou de type polyoléfine comme le polyéthylène (PE), le polypropylène (PP), ou de type polyamide.

11. Structure multicouche selon l'une des revendications 1 à 10, comportant une couche (4) en matériau polymère sur la couche (A) de SiO₂ du premier empilement sur la face opposée à celle en contact avec la couche (B) en matériau de type SiOₓN_{y}H_{z}.

12. Structure multicouche selon l'une des revendications 1 à 10, comportant n empilements, n étant un entier positif supérieur ou égal à 1, chaque empilement comportant chacun une couche de (SiO₂)ᵢ et une couche en matériau de type SiOₓᵢN_{yi}H_{zi}, i étant un entier positif compris entre 1 et n, les couches de (SiO₂)ᵢ et en matériau de type SiOₓᵢN_{yi}H_{zi} de chaque empilement ayant des épaisseurs (e_{B}, e_{A}) telles que l'épaisseur des couches (A) de (SiO₂)ᵢ est inférieure ou égale 60 nm, l'épaisseur des couches (B) en matériau de type SiOₓᵢN_{yi}H_{zi} (e_{B}) est supérieure à deux fois l'épaisseur (e_{A}) de la couche (A) de (SiO₂)ᵢ et la somme des épaisseurs de la couche (A) de (SiO₂)ᵢ et de la couche (B) en matériau de type SiOₓᵢN_{yi}H_{zi} est comprise entre 100 nm et 500 nm et dans laquelle zᵢ est strictement inférieur au rapport (xᵢ+yᵢ)/5, avantageusement zᵢ est strictement inférieur au rapport (xᵢ+yᵢ)/10, xᵢ, yᵢ, zᵢ étant identiques ou non pour les différents valeurs de i.

13. Structure multicouche selon la revendication 12, comportant au moins une couche en matériau polymère disposée entre la couche de (SiO₂)ᵢ d'un empilement et la couche en matériau de type SiOₓᵢN_{yi}H_{zi} de l'empilement suivant directement.

14. Structure multicouche selon la revendication 13, comportant n-1 couches en matériau polymère, chacune des couches en matériau polymère étant disposée entre deux empilements.

15. Procédé de réalisation d'une structure multicouche selon l'une des revendications 1 à 14, comportant :
a) le dépôt sur un substrat d'un précurseur inorganique liquide de type perhydropolysilazane,
b) la conversion par irradiation par des rayonnements VUV à une longueur d'onde inférieure ou égale à 220 nm et un rayonnement ultraviolet à une longueur d'onde supérieure ou égale à 220 nm sous une atmosphère présentant un taux d'oxygène supérieur à 10 ppm et inférieur à 500 ppm et un taux d'eau inférieur ou égal à 1000 ppm, de sorte à former un empilement d'une couche de SiO₂ et une couche en matériau de type SiOₓN_{y}H_{z}.

16. Procédé de réalisation selon la revendication 15, comportant l'étape c) de dépôt d'une couche de matériau polymère après l'étape b).

17. Procédé de réalisation selon la revendication 15 ou 16, comportant la répétition des étapes a) et b) ou a), b) et c).

18. Procédé de réalisation d'une structure multicouche selon l'une des revendications 1 à 14, comportant:
a') le dépôt sur un substrat d'un précurseur inorganique liquide de type perhydropolysilazane sur le substrat,
b') la conversion par irradiation par des rayonnements ultraviolet à une longueur d'onde supérieure à 220 nm sous une atmosphère présentant un taux d'oxygène et un taux d'eau inférieurs à 10 ppm,
c') le dépôt sur la couche formé à l'étape b', d'un précurseur inorganique liquide de type perhydropolysilazane sur le substrat,
d') la conversion par irradiation par des rayonnements VUV à une longueur d'onde inférieure ou égale à 220 nm sous une atmosphère présentant un taux d'oxygène supérieur à 10 ppm et inférieur à 500 ppm.

## Patentansprüche

1. Mehrschichtige Struktur, enthaltend ein Substrat (2) und eine erste Stapelung aus einer Schicht (A) aus SIO₂, einer Schicht (B) aus einem Material vom Typ SiOₓN_{y}H_{z}, die zwischen dem Substrat (2) und der Schicht (A) aus SiO₂ angeordnet ist, wobei die Schicht (A) aus SiO₂ und die Schicht (B) aus Material vom Typ SiOₓN_{y}H_{z} solche Materialdicken (e_{B}, e_{A}) aufweisen, dass die Materialdicke der Schicht (A) aus SiO₂ geringer oder gleich 60 nm ist, die Materialdicke der Schicht (B) aus Material vom Typ SiOₓN_{y}H_{z} (e_{B}) größer als die zweifache Materialdicke (e_{A}) der Schicht (A) aus SiO₂ ist und die Summe der Materialdicken der Schicht (A) aus SiO₂ und der Schicht (B) aus Material vom Typ SiOₓN_{y}H_{z} zwischen 100 nm und 500 nm beträgt und wobei z strikt positiv und strikt geringer als das Verhältnis (x + y) / 5 ist, wobei vorteilhaft z strikt geringer als das Verhältnis (x + y) /10 ist.

2. Mehrschichtige Struktur nach Anspruch 1, wobei der Wert von x ausgehend von der Schnittstelle zwischen der Schicht aus Material vom Typ SiOₓN_{y}H_{z} (B) und der Schicht aus SiO₂ zum Substrat hin abnimmt und der Wert von y ausgehend von der Schnittstelle zwischen der Schicht aus Material vom Typ SiOₓN_{y}H_{z} (B) und der Schicht aus SiO₂ zum Substrat hin zunimmt.

3. Mehrschichtige Struktur nach Anspruch 2, wobei x von 2 bis 0 variiert und/oder y von 0 bis 1 variiert.

4. Mehrschichtige Struktur nach einem der Ansprüche 1 bis 3, wobei das Material der Schicht (A) aus SiO₂ ein Young-Modul größer oder gleich 30 GPa aufweist und die Schicht (B) aus Material vom Typ SiOₓN_{y}H_{z} ein Young-Modul (MB) geringer oder gleich 20 GPa hat.

5. Mehrschichtige Struktur nach einem der Ansprüche 1 bis 4, deren Stapelung einen Brechungsindex von über 1,5 aufweist.

6. Mehrschichtige Struktur nach Anspruch 4 oder 5, wobei die Stapelung bzw. Stapelungen durch Umwandlung eines anorganischen Vorläufers vom Typ Perhydropolysilazan erhalten wird bzw. werden, wobei die Stapelung eine der Verbindung Si-H entsprechende Durchlässigkeit aufweist, die größer als 80 %, vorteilhaft größer als 90 % der Durchlässigkeit der Si-H-Verbindung des anorganischen Vorläufers vom Typ Perhydropolysilazan vor der Umwandlung ist, gemessen durch Infrarot-Reflexions-Spektrometrie im Falle eines Substrats aus Polymermaterial.

7. Mehrschichtige Struktur nach Anspruch 4 oder 5, wobei die Stapelung bzw. Stapelungen durch Umwandlung eines anorganischen Vorläufers vom Typ Perhydropolysilazan erhalten wird bzw. werden, wobei die Stapelung eine der Verbindung Si-H entsprechende Absorbanz aufweist, die geringer als 20 %, vorteilhaft geringer als 10 % der Absorbanz der Si-H-Verbindung des anorganischen Vorläufers vom Typ Perhydropolysilazan vor der Umwandlung ist, gemessen durch Infrarot-Transmissions-Spektrometrie im Falle eines Substrats aus Silicium.

8. Mehrschichtige Struktur nach einem der Ansprüche 1 bis 7, wobei die Schicht (A) aus SiO₂ und die Schicht (B) aus Material vom Typ SiOₓN_{y}H_{z} aus amorphen Materialen bestehen.

9. Mehrschichtige Struktur nach einem der Ansprüche 1 bis 8, wobei das Substrat (2) aus Polymermaterial besteht.

10. Mehrschichtige Struktur nach Anspruch 9, wobei das Substrat (2) ein Polymermaterial vom Typ Polyester, wie Polyethylenterephthalat (PET), Polyethylennaphthalat (PEN) oder vom Typ Polyolefin, wie Polyethylen (PE), Polypropylen (PP) oder vom Typ Polyamid ist.

11. Mehrschichtige Struktur nach einem der Ansprüche 1 bis 10, enthaltend eine Schicht (4) aus Polymermaterial an der Schicht (A) aus SiO₂ der ersten Stapelung an der Seite, die derjenigen entgegengesetzt ist, die in Kontakt mit der Schicht (B) aus Material vom Typ SiOₓN_{y}H_{z} ist.

12. Mehrschichtige Struktur nach einem der Ansprüche 1 bis 10, enthaltend n Stapelungen, wobei n eine ganze positive Zahl größer oder gleich 1 ist, wobei jede Stapelung jeweils eine Schicht aus (SiO₂)ᵢ aufweist, und eine Schicht aus Material vom Typ SiOₓᵢN_{yi}H_{zi}, wobei i eine ganze positive Zahl zwischen 1 und n ist, wobei die Schichten aus (SiO₂)ᵢ und aus Material vom Typ SiOₓᵢNyᵢH_{zi} einer jeden Stapelung solche Materialdicken (e_{B}, e_{A}) haben, dass die Materialdicke der Schichten (A) aus (SiO₂)ᵢ geringer oder gleich 60 nm ist, die Materialdicke der Schichten (B) aus Material vom Typ SiOₓᵢN_{yi}H_{zi} (e_{B}) größer als die zweifache Materialdicke (e_{A}) der Schicht (A) aus (SiO₂)ᵢ und die Summer der Materialdicken der Schicht (A) aus (SiO₂)ᵢ und der Schicht (B) aus Material vom Typ SiOₓᵢN_{yi}H_{zi} zwischen 100 nm und 500 nm liegt und wobei z strikt geringer als das Verhältnis (xᵢ + yᵢ) / 5 ist, wobei z vorteilhaft strikt geringer als das Verhältnis (xᵢ + yᵢ) / 10 ist, wobei xᵢ, yᵢ, zᵢ für die verschiedenen Werte von i identisch oder nicht identisch sind.

13. Mehrschichtige Struktur nach Anspruch 12, enthaltend zumindest eine Schicht aus Polymermaterial, die zwischen der Schicht aus (SiO₂)ᵢ einer Stapelung und der Schicht aus Material vom Typ SiOₓᵢN_{yi}H_{zi} der unmittelbar darauffolgenden Stapelung angeordnet ist.

14. Mehrschichtige Struktur nach Anspruch 13, enthaltend n-1 Schichten aus Polymermaterial, wobei jede der Schichten aus Polymermaterial zwischen zwei Stapelungen angeordnet ist.

15. Verfahren zum Herstellen einer mehrschichtigen Struktur nach einem der Ansprüche 1 bis 14, umfassend:
a) Aufbringen eines flüssigen, anorganischen Vorläufers vom Typ Perhydropolysilazan auf ein Substrat,
b) Umwandeln durch Bestrahlen mit VUV-Strahlungen mit einer Wellenlänge unter oder gleich 220 nm und einer Ultraviolett-Strahlung mit einer Wellenlänge größer oder gleich 220 nm unter einer Atomsphäre mit einem Sauerstoffgehalt von über 10 ppm und unter 500 ppm und einem Wassergehalt unter oder gleich 1000 ppm, so dass eine Stapelung einer Schicht aus SiO und einer Schicht aus Material vom Typ SiOₓN_{y}H_{z} gebildet wird.

16. Herstellungsverfahren nach Anspruch 15, umfassend den Schritt c) des Aufbringens einer Schicht aus Polymermaterial nach dem Schritt b).

17. Herstellungsverfahren nach Anspruch 15 oder 16, umfassend das Wiederholen der Schritte a) und b) oder a), b) und c).

18. Verfahren zum Herstellen einer mehrschichtigen Struktur nach einem der Ansprüche 1 bis 14, umfassend :
a') Aufbringen auf ein Substrat von einem flüssigen, anorganischen Vorläufer vom Typ Perhydropolysilazan auf dem Substrat,
b') Umwandeln durch Bestrahlen mit Ultraviolett-Strahlungen mit einer Wellenlänge über 220 nm unter einer Atomsphäre mit einem Sauerstoffgehalt und einem Wassergehalt unter 10 ppm,
c') Aufbringen eines flüssigen, anorganischen Vorläufers vom Typ Perhydropolysilazan auf dem Substrat auf die in Schritt b' gebildete Schicht, auf ein Substrat,
d') Umwandeln durch Bestrahlen mit VUV-Strahlungen mit einer Wellenlänge geringer oder gleich 220 nm unter einer Atomsphäre mit einem Sauerstoffgehalt über 10 ppm und unter 500 ppm.

## Claims

1. A multilayer structure including a substrate (2), and a first stack of a layer (A) of SiO₂ and a layer (B) of material of the SiOₓN_{y}H_{z} type positioned between the substrate (2) and the layer (A) of SiO₂, in which the layer (A) of SiO₂ and the layer (B) of material of the SiOₓN_{y}H_{z} type have thicknesses (e_{B}, e_{A}) such that the thickness of the layer (A) of SiO₂ is less than or equal to 60 nm, the thickness of the layer (B) of material of the SiOₓN_{y}H_{z} type (e_{B}) is more than twice the thickness (e_{A}) of the layer (A) of SiO₂, and the sum of the thicknesses of the layer (A) of SiO₂ and of the layer (B) of material of the SiOₓN_{y}H_{z} type is between 100 nm and 500 nm, and in which z is strictly positive and is strictly less than the ratio (x+y)/5, and advantageously z is strictly less than the ratio (x+y)/10.

2. A multilayer structure according to claim 1, in which the value of x decreases from the interface between the layer of material of the SiOₓN_{y}H_{z} type (B) and the layer of SiO₂ towards the substrate, and the value of y increases from the interface between the layer of material of the SiOₓN_{y}H_{z} type (B) and the layer of SiO₂ towards the substrate.

3. A multilayer structure according to claim 2, in which x varies from 2 to 0 and/or y varies from 0 to 1.

4. A multilayer structure according to one of claims 1 to 3, in which the material of the layer (A) of SiO₂ has a Young's modulus of greater than or equal to 30 GPa, and the layer (B) of material of the SiOₓN_{y}H_{z} type has a Young's modulus (M_{B}) of less than or equal to 20 GPa.

5. A multilayer structure according to one of claims 1 to 4, the stack of which has a refractive index of greater than 1.5.

6. A multilayer structure according to claim 4 or 5, in which the stack or stacks is/are obtained by conversion of an inorganic precursor of the perhydropolysilazane type, where the stack has a transmittance corresponding to the Si-H bond of greater than 80%, advantageously greater than 90%, of the transmittance of the Si-H bond of the inorganic precursor of the perhydropolysilazane type before conversion, measured by infrared reflectance spectrometry in the case of a substrate made of polymer material.

7. A multilayer structure according to claim 4 or 5, in which the stack or stacks is/are obtained by conversion of an inorganic precursor of the perhydropolysilazane type, where the stack has an absorbance corresponding to the Si-H bond of less than 20%, advantageously less than 10%, of the absorbance of the Si-H bond of the inorganic precursor of the perhydropolysilazane type before conversion, measured by infrared transmission spectrometry in the case of a silicon substrate.

8. A multilayer structure according to one of claims 1 to 7, in which the layer (A) of SiO₂ and the layer (B) made of material of the SiOₓN_{y}H_{z} type are made of amorphous materials.

9. A multilayer structure according to one of claims 1 to 8, in which the substrate (2) is made of a polymer material.

10. A multilayer structure according to claim 9, in which the substrate 2 is a polymer material, of the polyester type such as polyethylene terephthalate (PET), polyethylene naphthalate (PEN), or of the polyolefine type such as polyethylene (PE), polypropylene (PP), or of the polyamide type.

11. A multilayer structure according to one of claims 1 to 10, including a layer (4) of polymer material on the layer (A) of SiO₂ of the first stack on the face opposite the one in contact with the layer (B) made of material of the SiOₓN_{y}H_{z} type.

12. A multilayer structure according to one of claims 1 to 10, including n stacks, where n is a positive integer greater than or equal to 1, where each stack includes a layer of (SiO₂)ᵢ and a layer of a material of the SiOₓᵢN_{yi}H_{zi} type, where i is a positive integer of between 1 and n, where the layers of (SiO2)ᵢ and of a material of the SiOₓᵢN_{yi}H_{zi} type of each stack have thicknesses (e_{B}, e_{A}) such that the thickness of the layers (A) of (SiO₂)ᵢ is less than or equal to 60 nm, the thickness of the layer (B) of the material of the SiOₓᵢN_{yi}H_{zi} type (e_{B}) is more than twice the thickness (e_{A}) of the layer (A) of (SiO₂)ᵢ, and the sum of the thicknesses of the layer (A) of (SiO₂)ᵢ and of the layer (B) of the material of the SiOₓᵢN_{yi}H_{zi} type is between 100 nm and 500 nm, and in which zᵢ is strictly less than the ratio (xᵢ+yᵢ)/5, and advantageously zᵢ is strictly less than the ratio (xᵢ+yᵢ)/10, where xᵢ, yᵢ and zᵢ may or may not be identical for the different values of i.

13. A multilayer structure according to claim 12, including at least one layer made of polymer material positioned between the layer of (SiO₂)ᵢ of a stack and the layer of material of the SiOₓᵢN_{yi}H_{zi} type of the stack which follows directly.

14. A multilayer structure according to claim 13, including n-1 layers made of polymer material, where each of the layers made of polymer material is positioned between two stacks.

15. A method for producing a multilayer structure according to one of claims 1 to 14, including:
a) deposition on a substrate of a liquid inorganic precursor of the perhydropolysilazane type,
b) conversion by irradiation by VUV radiation with a wavelength of less than or equal to 220 nm and an ultraviolet radiation with a wavelength of greater than or equal to 220 nm in an atmosphere with an oxygen content of greater than 10 ppm and less than 500 ppm and a water content of less than or equal to 1,000 ppm, so as to form a stack of a layer of SiO₂ and a layer of a material of the SiOₓN_{y}H_{z} type.

16. A production method according to claim 15 including step c) of deposition of a layer of polymer material after step b).

17. A production method according to claim 15 or 16, including the repetition of steps a) and b) or a), b) and c).

18. A method for producing a multilayer structure according to one of claims 1 to 14, including:
a') deposition on a substrate of a liquid inorganic precursor of the perhydropolysilazane type on the substrate,
b') conversion by irradiation by ultraviolet radiation with a wavelength of greater than 220 nm in an atmosphere having an oxygen content and a water content of less than 10 ppm,
c') deposition on the layer formed in step b' of a liquid inorganic precursor of the perhydropolysilazane type on the substrate,
d') conversion by irradiation by VUV radiation with a wavelength of less than or equal to 220 nm in an atmosphere having an oxygen content of greater than 10 ppm and less than 500 ppm.
